Europäisches Patentamt

(19) European Patent Office  (11) Publication number: **0 017 759**

Office européen des brevets  **B1**

(12) **EUROPEAN PATENT SPECIFICATION**

(45) Date of publication of patent specification: **04.09.85**  (51) Int. Cl.⁴: **G 03 B 41/00**

(21) Application number: **80101307.9**

(22) Date of filing: **13.03.80**

(54) **Improved step-and-repeat projection alignment and exposure system.**

(30) Priority: **03.04.79 US 26722**
**02.07.79 US 53995**

(43) Date of publication of application:
**29.10.80 Bulletin 80/22**

(45) Publication of the grant of the patent:
**04.09.85 Bulletin 85/36**

(84) Designated Contracting States:
**DE FR GB IT**

(56) References cited:
**FR-A-1 508 408**
**FR-A-2 082 213**
**FR-A-2 247 050**
**FR-A-2 375 631**
**FR-A-2 388 371**
**US-A-3 476 476**
**US-A-3 704 946**
**US-A-3 716 296**
**US-A-4 057 347**

(73) Proprietor: **EATON-OPTIMETRIX INC.**
**4001 North First Street**
**San Jose California 95134 (US)**

(72) Inventor: **Phillips, Edward H.**
**Post Office Box 1042**
**Middletown California 95461 (US)**
Inventor: **Johannsmeier, Karl-Heinz**
**400 Fir Lane**
**Los Altos California 94022 (US)**

(74) Representative: **Liesegang, Roland, Dr.-Ing.**
**Sckellstrasse 1**
**D-8000 München 80 (DE)**

## Description

This invention relates to a photometric printing apparatus including a holder for holding a first object in a first plane; a stage for holding a second object in a second plane; a light source unit, optically disposed on one side of the holder, for illuminating the first object; a projection lens, optically disposed on the other side of the holder and between the holder and the stage, for projecting an image of illuminated portions of the first object onto the second object; and control means, coupled to the stage, for moving the stage to facilitate printing of an image of an illuminated portion of the first object at different regions of the second object.

In the semiconductor industry projection lenses of the reduction type are employed both in the fabrication of photomasks and in the processing of semiconductive wafers to form integrated circuits and the like. A high (submicron) resolution photomask is typically fabricated by utilizing a precisely controlled stage to successively position adjacent regions of the photomask with respect to an image (formed by such a projection lens) of a reticle containing a level of microcircuitry that is printed on the photomask at each of those regions. This step-and-repeat printing operation forms an array of adjacent regions of microcircuitry of one level on the photomask in rows and columns parallel to the coordinate axes of motion of stage. A set of such photomasks, each bearing an array of microcircuitry of a different level, is typically employed in the fabrication of integrated circuits or the like from a semiconductive wafer. In the course of this fabrication, the semiconductive wafer is sequentially aligned with each photomask of the set and the level of microcircuitry printed on the photomask is in turn printed on the semiconductive wafer. However, it is also possible to eliminate the operation of fabricating a set of such photomasks by employing a precisely controlled stage to successively position adjacent regions of the semiconductive wafer with respect to each of the reticles employed in fabricating the set of photomasks so that the level of microcircuitry contained on each of those reticles may be printed directly on the semiconductive wafer at each of those regions during separate step-and-repeat printing operations.

In order to facilitate the precise positioning or alignment of one level of microcircuitry being printed on a semiconductive wafer at each of an array of adjacent regions thereof relative to another level of microcircuitry previously printed or yet to be printed on the semiconductive wafer at each of those same regions, it would be highly desirable to employ a step-and-repeat alignment and exposure system utilizing a projection lens of the reduction type in the optical portion thereof while allowing direct viewing and alignment of the reticle, or an image of the reticle, with respect to the coordinate axes of motion of the state, and further allowing direct viewing and alignment of microcircuitry previously printed on the semiconductive wafer at each of those regions with respect to the reticle, or image of the reticle. Unfortunately, however, conventional step-and-repeat alignment and exposure systems utilizing projection lenses of the reduction type do not allow such direct viewing and alignment of either the reticle, or an image of the reticle, or the semiconductive wafer.

In order, for example, to facilitate the precise positioning or alignment of one level of microcircuitry being printed on a semiconductive wafer at each of an array of adjacent regions thereof relative to another level of microcircuitry previously printed or yet to be printed on the semiconductive wafer at each of those same regions, it would be highly desireable to employ a precisely controlled stage having a visible indicium of at least one of the coordinate axes of motion of the stage so as to facilitate the precise and repeatable positioning of a photomask or a reticle with respect to that axis of motion of the stage. Unfortunately, however, the stages employed in conventional step-and-repeat alignment and exposure systems do not have such an indicium.

In a known device of the kind initially described US—A—3,476,476) a condenser is used to image the light source unit into the projection lens. The known device however, does not provide optical means to control the configuration of light in the reticle plane in such a manner as to selectively illuminate different parts of the reticle. It is the main problem to be solved by this invention to provide means permitting control of the configuration of light at the first (reticle) plane, e.g. allowing different parts of the first object (reticle) to be illuminated selectively. This problem is solved by a photometric printing apparatus of the kind described initially, which according to the invention is characterized in that the light source unit includes an imaging lens and a field lens for defining a third plane conjugate to the plane of the first object; and in that the imaging lens is located between the first and third planes and that the field lens is located adjacent to the first plane.

While it would be possible to move the first object reticle for viewing, alignment and exposure it is much easier to move the stage holding the second object (wafer) as moving the first object (reticle) would involve problems due to the larger dimensions and weight of a movable stage holding the first object. Without moving the first object (reticle) exposure light or illuminating light may be used thus avoiding inadvertant exposure.

The apparatus of the invention may include a projection lens of the reduction type in the optical portion thereof while allowing direct viewing and alignment of an image of a first object, such as a reticle, and of a second object, such as a semiconductive wafer.

The image plane of the projection lens may preferably be observed through a viewing port.

Different portions of the reticle may selectively be illuminated by means of a masking apparatus.

The controlled movable stage may be provided with a visible reference mark that is indicative of at least one of coordinate axes of motion of the stage.

The apparatus of the invention may preferably comprise a reticle alignment subsystem for precisely and repeatably aligning an image of each reticle of a set of different reticles with respect to the axes of motion of the controlled movable stage.

Further the apparatus of the invention may advantageously comprise a wafer alignment subsystem for precisely aligning a previously printed array of adjacent regions of microcircuitry on the semiconductive wafer with respect to the axes of motion of the controllable movable stage and/or with respect to an image of each reticle of a set of different reticles.

The invention and its objects, effects and advantages are further illustrated at hand of drawings of a preferred embodiment in the following detailed description.

Figures 1A—C are perspective views of different portions of a step-and-repeat alignment and exposure system in accordance with the preferred embodiment of the present invention, wherein Fig. 1C may be imagined on the left-hand side of Fig. 1A and linked with Fig. 1A via beams 87A in Fig. 1A and wherein Fig. 1B may be imagined in a position above Fig. 1A and linked with Fig. 1A via vertical beam 34E;

Figure 2 is a half-sectional, partially cut-away elevational view of a portion of the step-and-repeat alignment and exposure system of Figures 1A—C.

Figure 3 is a plan view of a slide holding two different masks employed in the step-and-repeat alignment and exposure system of Figures 1A—C.

Figure 4 is a plan view of one of a pair of reticle alignment marks contained on each reticle employed with the step-and-repeat alignment and exposure system of Figures 1A—C.

Figure 5 is a half-sectional elevational view of a portion of the step-and-repeat alignment and exposure system of Figures 1A—C.

Figure 6 is a plan view of the semiconductive wafer illustrating the manner in which a step-and-repeat printing operation is performed by the step-and-repeat alignment and exposure system of Figures 1A—C.

Description of the preferred embodiment

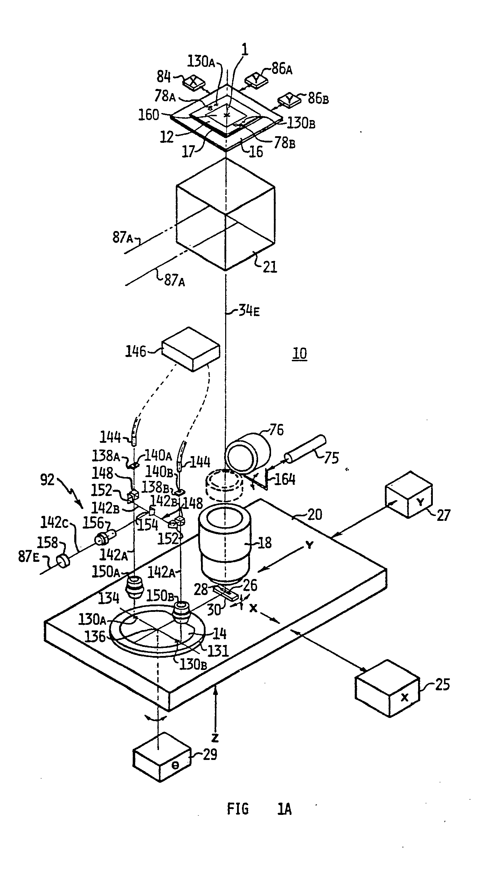

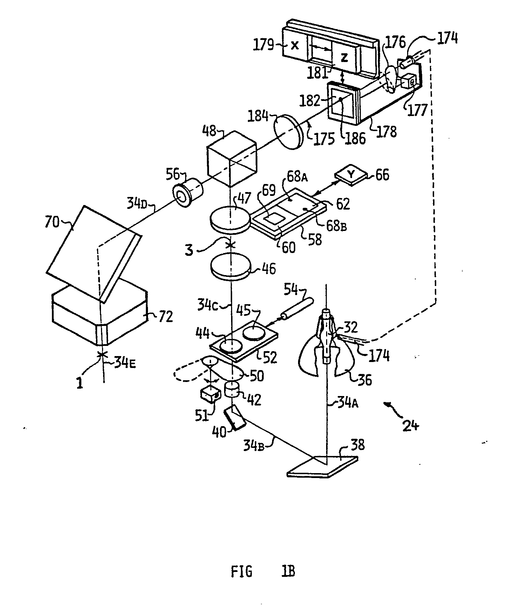

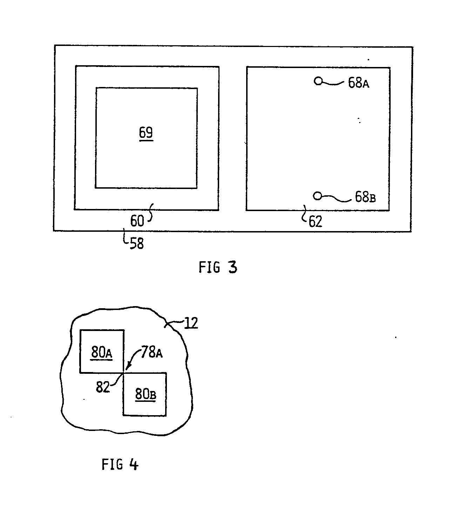

Referring now to Figures 1A—C and 2, there is shown a precision step-and-repeat alignment and exposure system 10 for repeatedly printing one level of microcircuitry, contained on a first object, such as a reticle 12, at an array of adjacent regions of a second object, such as a semiconductive wafer 14, in alignment with other levels of microcircuitry previously printed or yet to be printed at those same regions. Alignment and exposure system 10 includes a stage 16 for holding the reticle 12, a 10:1 projection lens 18 for projecting an image of illuminated portions of the reticle onto a reference mark 26 or the semiconductive wafer 14, a main stage 20 for positioning the reference mark or the semiconductive wafer with respect to the projected image of the illuminated portions of the reticle, a beam splitter 21 and a compound microscope 22 for viewing aerial images of portions of the reference mark or semiconductive wafer illuminated by the projected image of the reticle, and a light source unit 24 for selectively illuminating different portions of the reticle (with either illumination or exposure light) for viewing those aerial images during alignment operations and for selectively exposing a photosensitive film on the semiconductive wafer during step-and-repeat printing operations.

With reference now particularly to Figure 1A, main stage 20 may comprise an interferometrically-controlled stage of the type shown and described in detail in copending European Patent Publication No. 36026. As fully described in that application, main stage 20 may be moved along orthogonal X and Y axes to any position in a horizontal plane by X and Y axes servo drive units 25 and 27. Either axis of motion of main stage 20 may therefore be employed as an absolute frame of reference, and the X axis is so employed, for alignment and exposure system 10, as hereinafter explained.

Reference mark 26 may be formed of bright chrome on a reference mark plate 28 fixedly mounted on a substage 30, which is in turn adjustably mounted on main stage 20.

With reference now particularly to Figure 1B, light source unit 24 includes a mercury arc lamp 32 for emitting a spectrum of light energy including both green illuminating light have a wave length of about 547 nanometers for illuminating but not exposing the photosensitive film on semiconductive wafer 12, and blue illuminating and exposure light having a wavelength of about 436 nanometers for both illuminating and exposing the photosensitive film on the semiconductive wafer (herein simply referred to as exposure light). Mercury arc lamp 32 is fixedly mounted along a vertically extending portion 34a of an optical path 34a-e of alignment and exposure system 10. An elliptical reflector 36 surrounds mercury arc lamp 32 and is fixedly coaxially mounted therewith for projecting a beam of light emitted by the mercury arc lamp downward to a band reflecting plane mirror 38. This band reflecting plane mirror 38 has a multilayer dielectric coating for reflecting blue and green light, but transmitting all other light, in the beam of light to prevent unnecessary energy from being transmitted along the remaining portions of optical path 34a-e. Band reflecting plane mirror 38 is fixedly mounted in optical path 34a-e at an angle of forty-five degrees with respect to the vertically extending portion 34a thereof so as to deflect the blue and green light in the beam of light along a horizontally extending portion 34b of that optical path to a plane mirror 40.

Plane mirror 40 is fixedly mounted in optical path 34a-e at an angle of forty-five degrees with respect to the horizontally extending portion 34b thereof so as to deflect the beam of blue and green light incident thereon upward along another vertically extending portion 34c of that optical path. The beam of light so deflected thereupon passes through a light integrator 42 and, when a normally closed shutter 50 is opened as during the substage adjustment operation, also through a blue or a green filter 44 or 45 and a pair of positive lenses 46 and 47 to a beam splitter 48. Light integrator 42 is fixedly mounted in the vertically extending portion 34c of optical path 34a-e and is employed for providing the beam of light passing therethrough with a cross section corresponding to the entrance pupil of projection lens 18 and with a uniform intensity distribution in the plane of reticle 12.

Shutter 50 is pivotally mounted adjacent to the vertically extending portion 34c of optical path 34a-e and is controlled by a θ servo drive unit 51 for pivotal movement into that optical path (as shown in solid lines) when closed so as to block passage of the beam of light therealong and for pivotal movement out of that optical path (as shown in dashed lines) when opened so as to permit passage of the beam of light therealong. Blue filter 44 and green filter 45 are fixedly mounted in horizontally spaced relationship on a slide 52 which is in turn reciprocally mounted in a horizontal plane orthogonally intersecting the vertically extending portion 34c of optical path 34a-e. Slide 52 is moved along the Y axis under control of an air cylinder 54 to position either the blue filter 44 or the green filter 45 in the path of the beam of blue and green light passing upward along the vertically extending portion 34c of optical path 34a-e when shutter 50 is opened. Blue filter 44 is normally so positioned and therefore passes the blue light in the beam of light to the pair of positive lenses 46 and 47 while filtering out the green light and any other non-blue light that may still be present in the beam of light.

Positive lenses 46 and 47 are fixedly mounted in the vertically extending portion 34c of optical paths 34a-e to image the output of light integrator 42 at the entrance pupil of an imaging lens 56. A slide 58 is mounted for movement along the Y axis under control of a Y axis servo drive unit 66 to selectively position either of two separate mask plates 60 and 62 at an operative position directly between positive lenses 46 and 47 in a horizontal plane orthogonally intersecting the vertically extending portion 34c of optical path 34a-e at a point midway between those positive lenses. Light appearing in this plane between positive lenses 46 and 47 is imaged onto reticle 12. During the substage adjustment operation, slide 58 is moved by Y axis servo drive unit 66 to locate mask plate 62 in an operative position between positive lenses 46 and 47 so that a pair of small circular openings 68a and 68b of mask plate 62 (best shown in Figure 3), permit the blue light passed by blue filter 44 to illuminate a corresponding pair of circular areas about 2 millimeters in diameter disposed on the surface of reticle 12 and containing a pair of reticle alignment marks 78a and 78b, respectively.

Beam splitter 48 is fixedly mounted in the vertically extending portion 34c of optical path 34a-e so as to reflect eighty percent of the incident light along a horizontally extending portion 34d of that optical path through imaging lens 56 to a plane mirror 70. Imaging lens 56 is fixedly mounted along the horizontally extending portion 34d of optical path 34a-e and is employed to image the light passing through mask plate 62 at the surface of reticle 12. Plane mirror 70 is fixedly mounted in optical path 34a-e at an angle of forty-five degrees with respect to the horizontally extending portion 34d thereof so as to deflect the light incident thereon downward along a vertically extending portion 34e of that optical path. This downwardly deflected light passes through a positive lens 72, reticle 12 and beam splitter 21 to projection lens 18. Positive lens 72 is fixedly mounted along the vertically extending portion 34e of optical path 34a-e so as to image light appearing at the output pupil of imaging lens 56 at the input pupil of projection lens 18.

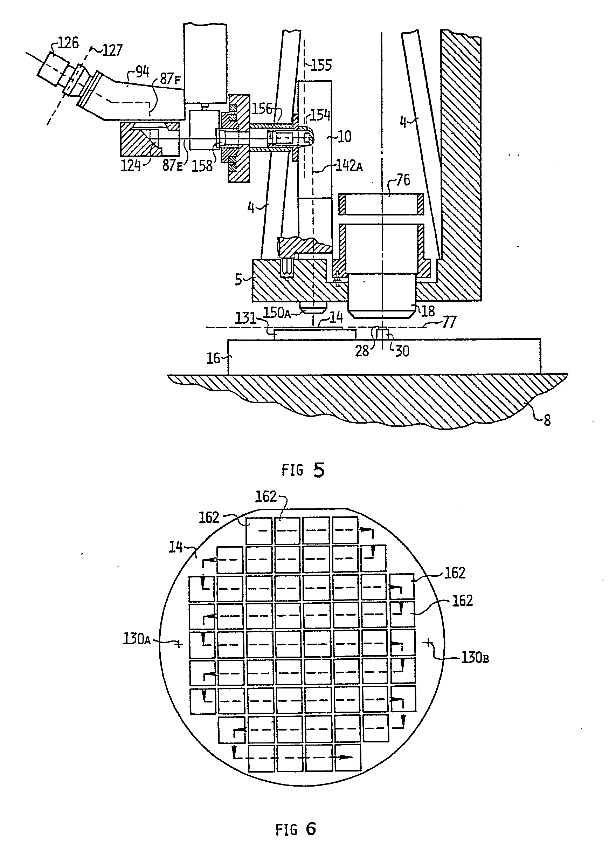

With reference now particularly to Figures 1A and 2, each reticle 12 to be employed with alignment and exposure system 10 has a pair of oppositely-facing reticle alignment marks 78a and 78b spaced 103 millimeters apart (center-center-to-center) along the X axis when the reticle is properly aligned on stage 16. As best shown in Figure 4, each reticle alignment mark 78a or 78b may comprise a pair of light or transparent windows 80a and 80b (each about 0.75 millimeters square) on a dark or opaque field. These windows 80a and 80b are symmetrically disposed about the center 82 of the alignment mark on opposite sides of a pair of orthogonal center-lines of the alignment mark (one of those centerlines being coincident with a common centerline of both alignment marks). Stage 16 is provided with a vacuum holder 17, as shown in Figure 2, for releasably holding reticle 12 in place, and is moved by X and differentially-controlled Y axes servo drive units 84, 86a and 86b to adjust the X, Y and θ orientation of the reticle as required to precisely align the reticle alignment marks 78a and 78b of the reticle with reference mark 26 as hereinafter explained.

Bean splitter 21 is mounted in the vertically extending portion 34e of optical path 34a-e so as to pass eighty percent of the light passing through reticle 12 to projection lens 18, which is also mounted in that portion of optical path 34a-e. A compensating lens 76 is pivotally mounted adjacent to projection lens 18 and controlled by a crank 74 and an air cylinder 75 for movement out of the vertically extending portion 34e of optical path 34a-e (as shown in solid lines) when blue light is passing therealong to the projection lens as is normally the case, and for movement into the vertically extending portion 34e of that optical path (as shown in dashed lines) when green light is passing therealong to the projection lens. The compensating lens 76 is employed to compensate for the difference in wavelength of the green light and the blue light since projection lens 18 is corrected for the blue light only.

Projection lens 18 focuses the light passing through reticle 12 at the first image plane 77 adjacent to main stage 20 and directly beneath the projection lens, thereby projecting images of illuminated portions of reticle 12 (and, hence, of the reticle alignment marks 78a and 78b contained on the reticle and illuminated by mask plate 62 when shutter 50 is opened) onto whatever object is positioned in that image plane directly beneath the projection lens. The portions of that object onto which those images are projected are therefore illuminated by the blue light passing through the transparent reticle alignment marks 78a and 78b on reticle 12. Twenty percent of the light reflected vertically upward from those portions of that object through projection lens 18 is reflected by beam splitter 21 along horizontally extending portions 87a of a dual optical path 87a-f to a second image plane 79 positioned the same optical distance from the beam splitter as is the reticle 12 and positioned between the beam splitter and objective lenses 88a and 88b of compound microscope 22. Projection lens 18 focuses this reflected light at the second image plane 79 thereby projects an aerial image of those portions of the object positioned in the first image plane 77 directly beneath the projection lens (i.e., those portions illuminated by the projected images of the reticle alignment marks 78a and 78b contained on the reticle 12) to the second image plane.

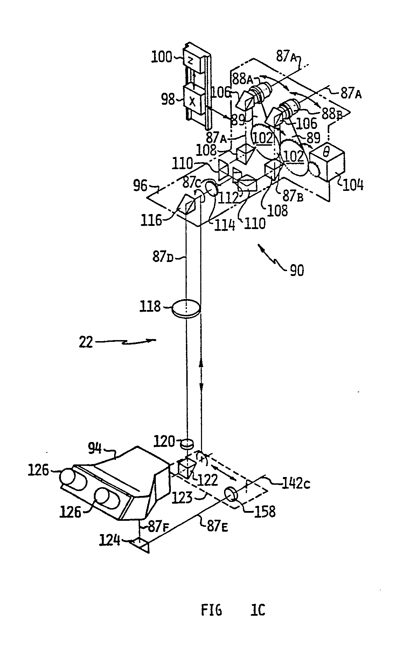

With reference now particularly to Figures 1C and 2, compound microscope 22 includes a first objective lens unit 90 employed in the substage adjustment operation being explained and in other precision alignment operations hereinafter explained, a second objective lens unit 92 employed in a precision prealignment operation hereinafter explained, and a binocular lens unit 93 employed with both the first and the second objective lens units as hereinafter explained. The first objective lens unit 90 is mounted on a stage 96 horizontally movable along the X axis under control of an X axis servo drive unit 98 and vertically movable along a Z axis orthogonal to the X and Y axes under control of a Z axis servo drive unit 100. Each of the objective lenses 88a and 88b comprises a 5:1 objective lens mounted on an associated arm 89, which is in turn pivotally mounted on stage 96 and coupled by a gear mechanism 102 to a θ servo drive unit 104 (both of which are also mounted on stage 96) for moving the objective lenses closer together or further apart. Objective lenses 88a and 88b are disposed along corresponding one of the horizontally extending portions 87a of dual optical path 87a-f adjacent to the second image plane 79 for receiving light therefrom. Thus, the objective lenses 88a and 88b can be moved with respect to the second image plane 79 as desired for viewing any portions of the aerial image projected to that plane.

A separate beam bender 106 is mounted on each arm 89 along each horizontally extending portion 87a of dual optical path 87a-f for deflecting light passing through the corresponding objective lens 88a or 88b generally downward along a corresponding downwardly extending portion 87b of dual optical path 87a-f to another corresponding beam bender 108. Each beam bender 108 is mounted on the same arm 89 as the corresponding beam bender 106 for pivotal movement therewith as the objective lenses 88a and 88b are moved closer together or further apart. Beam benders 108 are mounted along the corresponding downwardly extending portions 87b of dual optical path 87a-f for deflecting light from the corresponding beam benders 106 along corresponding horizontally extending portions 87c of dual optical path 87a-f to corresponding beam benders 110 from which that light is deflected along other corresponding horizontally extending portions 87c of dual optical path 87a-f to corresponding faces of a split field prism 112. Split field prism 112 in turn deflects light from each beam bender 110 in side-by-side relationship along a common horizontally extending portion 87c of dual optical path 87a-f through a field lens 114 to another beam bender 116. Beam benders 110, split field prism 112, and field lens 114 are fixedly mounted on stage 96 along the respective horizontally extending portion 87c of dual optical path 87a-f.

Beam bender 116 is mounted along the common horizontally extending portion 87c of dual optical path 87a-f for swivel movement thereabout and is disposed for deflecting light passing through field lens 114 downward along a downwardly extending portion 87d of that dual optical path through positive lenses 118 and 120 to a beam bender 122. Positive lenses 118 and 120 and beam bender 122 are mounted along the downwardly extending portion 87d of dual optical path 87a-f for swivel movement with beam bender 116 about the common horizontally extending portion 87c of that dual optical path, and to allow relative axial movement between positive lens 118 (which is fixedly mounted in a first tube 119 in fixed relation to beam bender 116) and positive lens 120 (which is fixedly mounted on a second tube 121 in fixed relation to beam bender 122, the first and second tubes 119 and 121 being slidably and coaxially disposed one within the other) as the length of the downwardly extending portion 87d of the dual optical path is changed by relative movement of beam benders 116 and 122. Thus, the downwardly extending portion 87d of dual optical path 87a-f may be moved by a manually controlled X axis slide 123, on which beam bender 122 is mounted, to locate beam bender 122 in an operative position along a horizontally extending portion 87e of dual optical path 87a-f whenever the first objective lens unit 90 is to be employed with binocular lens unit 93, such as in the substage adjustment operation. In this operative position beam bender 122 deflects light passing through positive lenses 118 and 120 forward along the horizontally extending portion 87e of dual optical path 87a-f to a beam bender 124. This beam bender 124 is fixedly mounted along the horizontally extending portion 87e of dual optical path 87a-f for deflecting light from beam bender 122 upward along a vertically extending portion 87f of dual optical path 87a-f to ocular lenses 126 of binocular head 94, which is fixedly mounted along that portion of the dual optical path.

The various elements of the first objective lens unit 90 and binocular lens unit 93 are arranged along dual optical path 87a-f as described above so that the aerial image viewed in the second image plane 79 by objective lenses 88a and 88b is reimaged at a third image plane 113 directly in front of split field prism 112. Positive lens 118 is provided with a focal length equal to the distance back along dual optical path 87a-f to the third image plane 113, and positive lens 120 is provided with a focal length equal to the distance forward along that dual optical path to a fourth image plane 127 directly in front of ocular lenses 126. Positive lenses 118 and 120 therefore serve as a relay lens unit for reimaging the reimage appearing in the third image plane 113 at the fourth image plane 127 and for accommodating changes in the length of the downwardly extending portion 87d of dual optical path 87a-f while transmitting light passing between those positive lenses in parallel rays as required to maintain proper focus.

As shown in Figure 2 and described in copending European Patent Publication No. 17044 stage 16, beam splitter 21, and projection lens 18 (and, hence, also compensating lens 76) are securely mounted on a tower 2. This tower 2 comprises an upper platform 3 on which stage 16 and beam splitter 21 are mounted, six upright rods 4 on which the upper platform is securely mounted, and a base 5 on which the rods 4 and the projection lens 18 (and, hence, compensating lens 76) are securely mounted. Stage 16, the reticle holder 17 mounted thereon, and the upper platform 3 of tower 2 are provided with clearance openings 6 permitting light passing through the reticle 12 to pass along the vertically extending portion 34e of dual optical path 34a-f through projection lens 18 to whatever object is positioned directly beneath the projection lens. The base 5 of tower 2 is mounted by air bearings on a casting 7, which is in turn fixedly mounted on a granite block 8 on which main stage 20 is mounted. Base 5 of tower 2 is vertically movable with respect to the casting 7 (and, hence, granite block 8) so as to permit vertical movement of the tower and, hence projection lens 18 relative to main stage 20 under control of an automatic optical focusing system described in European Patent Publication No. 17044. All of the elements of the first objective lens unit 90 and of the binocular lens unit 93 are securely mounted on an upright portion 9 of casting 7, while all of the elements of the second objective lens unit 92 are securely mounted on an upright portion 10 of the base 5 of tower 2 for vertical movement with the tower 2. In addition, all of the elements of light source unit 24 shown in Figure 1B are mounted on an upright post (not shown) which is in turn rotatably mounted on casting 7 so as to permit those elements to be pivoted away from the other portions of alignment and exposure system 10 for ease of service.

Referring now to Figures 1A—C and 2, the substage adjustment operation is performed by employing the X and Y servo drive units 25 and 27 for moving main stage 20 so as to position reference mark plate 28 directly beneath projection lens 18 with the end portions of reference mark 26 (which is nominally oriented along the X axis) illuminated by the projected images of reticle alignment marks 78a and 78b (i.e., by the blue light passing through those reticle alignment marks) contained on reticle 12. Concomitantly, the X and Z axes servo drive units 98 and 100 and the θ servo drive unit 104 are employed for moving stage 96 and spacing objective lenses 88a and 88b of the first objective lens unit 90 so as to position those objective lenses for viewing the aerial images of the illuminated end portions of reference mark 26. Since prior to adjustment of substage 30, reference mark plate 28 is likely disposed adjacent to and intersecting, rather than in, the first image plane 77, both of these aerial images of the illuminated end portions of reference mark plate 28 will be out of focus (one end portion likely being disposed above the other end portion below the first image plane). While viewing these out-of-focus aerial images, the operator manually adjusts substage 30 with respect to the plane of main stage 20, and the automatic focusing system described in European Patent Publication No. 17044 automatically moves tower 2 so as to track the average pivotal movement of the substage until both of these aerial images are brought into focus. At this point reference mark plate 28 is precisely positioned in and parallel to the first image plane 77 and the aerial image of the end portions of reference mark 26 illuminated by the projected images of reticle alignment marks 78a and 78b contained on reticle 12 are in focus.

While employing one of the objective lenses of the first objective lens unit (for example, the right hand objective lens 88b) to view one of the focused aerial images (for example, the aerial image of the end portion of reference mark 26 illuminated by the projected image of the right hand reticle alignment mark 78b), the operator employs the X axis servo drive unit 25 for moving main stage 20 back and forth along the X axis in a shuttle mode so as to alternately position each end portion of the reference mark in the projected image of the right hand reticle alignment mark 78b and thereby pass reference mark 26 back and forth through that projected image as shown in Figure 6. If reference mark 26 is not precisely aligned with the X axis of motion of main stage 20, this back-and-forth movement of the main stage causes the illuminated portion of reference mark 26 to rise and fall within the projected image of the right hand reticle alignment mark 78b. The operator thereupon adjusts the angular position of substage 30 until the illuminated portion of reference mark 26 does not rise and fall within the projected image of the right hand reticle alignment mark (i.e., remains in the position shown in Figure 6) as main stage 20 is moved back and forth. This precisely aligns reference mark 26 with the X axis of motion of main stage 20 and establishes the reference mark as an absolute frame of reference for precision alignment operations to be performed with alignment and exposure system 10 as hereinafter explained.

A set of n difference reticles 12, each containing a different level of microcircuitry to be successively printed at each of an array of adjacent regions of semiconductive wafer 14 in alignment with other levels of microcircuitry previously printed or yet to be printed at those same regions, is employed in the fabrication of integrated circuits or the like from the semiconductive wafer. Following the substage adjustment operation (and one other set-up operation hereinafter described), alignment and exposure system 10 may be successively employed with each reticle 12 of the set to successively perform each of these step-and-repeat printing operations on every semiconductive wafer 14 of a batch of semiconductive wafers being processed by the alignment and exposure system, as described below. Either the first reticle 12 of the first set of reticles to be employed with alignment and exposure system 10 or a special set-up reticle may be employed to perform the previously-described substage adjustment operation.

During each step-and-repeat printing operation, the reticle 12 being employed must first be precisely aligned with reference mark 26 on substage 30 and, hence, with the X axis of motion of main stage 20. This is accomplished by placing the reticle 12 on vacuum holder 17 of stage 16 in nominal alignment with the X axis of motion of main stage 20; by employing X and Y axis servo drive units 25 and 27 for moving the main stage to a position at which reference mark 26 is centered directly beneath projection lens 18 with the end portions of the reference mark nominally aligned with the images of the reticle alignment marks 78a and 78b of the reticle to be projected onto reference mark plate 28 when shutter 50 is opened; by employing Y axis servo drive unit 66 for moving slide 58 to a position at which mask plate 62 is located in the same operative position between positive lenses 46 and 47 as previously described; by employing θ servo drive unit 51 to opem shutter 50 so as to illuminate the reticle alignment marks 78a and 78b on the reticle and, hence, the end portions of reference mark 26 falling within the projected images of those reticle alignment marks; by employing slide 123 for moving beam bender 122 to the operative position in the horizontally extending portion 87e of optical path 87a-f as described above; by employing the X axis, Z axis, and θ servo drive units 98, 100, and 104, to position the objective lenses 88a and 88b for viewing the aerial images of the end portions of reference mark 26 illuminated by the images of the reticle alignment marks 78a and 78b projected onto those end portions; and while viewing those aerial images, by employing the X axis and differential Y axis servo drive units 84, 86a, and 86b for moving reticle 12 to precisely align the images of the reticle alignment marks 78a and 78b contained on the reticle with the illuminated end portions of reference mark 26. When so aligned the images of transparent windows 80a and 80b of each reticle alignment mark 78a and 78b are symmetrically disposed with respect to reference mark 26. It should be noted that many of the foregoing steps of the reticle alignment operation will already have been performed in the case of the first reticle of the first set of reticles being employed with alignment and exposure system 10 if that reticle is initially employed, rather than a special set-up wafer, in performing the previously described substage adjustment operation.

Once the first reticle 12 of the set has been aligned with reference mark 26 as described above, a pair of spaced wafer alignment marks 130a and 130b contained on the first reticle is printed on each semiconductive wafer 14 of the batch of semiconductive wafers being processed by alignment and exposure system 10. The wafer alignment marks 130a and 130b printed on semiconductive wafer 14 are employed to precision prealign the semiconductive wafer, as hereinafter explained in preparation for each step-and-repeat printing operation. The same pair of wafer alignment marks 130a and 130b can be employed in preparation for every step-and-repeat printing operation to be formed on semiconductive wafer 14 so long as that pair of wafer alignment marks does not become obliterated or obscured during those step-and-repeat printing operations or other processing operations following each step-and-repeat printing operation. Additional pairs of wafer alignment marks 130a and 130b may also be contained on the first reticle 12 and printed on semiconductive wafer 14 during the same wafer alignment mark printing operation in the event they should later be required.

The wafer alignment marks 130a and 130b contained on the first reticle 12 are spaced 103 millimeters apart and are disposed directly adjacent to and behind reticle alignment marks 78a and 78b. Each of these wafer alignment marks 130a and 130 comprises a light or transparent cross disposed on a dark or opaque field. In preparation for printing these wafer alignment marks 130a and 130b on each semiconductive wafer 14 of the batch being processed by alignment and exposure system 10, a photosensitive film is deposited over each semiconductive wafer of the batch. The wafer alignment mark printing operation is then successively performed on each semiconductive wafer 14 of the batch in the same manner as will now be described for the first semiconductive wafer of the batch.

The first semiconductive wafer 14 is placed on a vacuum chuck 131 mounted on main stage 20 for differential movement with respect to the plane of the main stage to permit parallel-plane alignment and focusing of the upper surface of the semiconductive wafer in the first image plane 77. The left hand wafer alignment mark 130a contained on the first reticle 12 is printed on the left hand side of the first semiconductive wafer 14 by employing Y axis servo drive unit 66 for moving slide 58 to locate mask plate 62 in an operative position between positive lenses 46 and 47 so as to illuminate small circular portions of the reticle containing the left and right hand wafer alignment marks 130a and 130b with blue light when shutter 50 is subsequently opened; by employing X and Y axes servo drive units 25 and 27 for moving main stage 20 to a position at which the left hand side of the semiconductive wafer is disposed directly beneath projection lens 18 so that when shutter 50 is subsequently opened the left hand wafer alignment mark 130a of the reticle will be imaged onto the left hand side of the semiconductive wafer at a location along a center line 134 thereof parallel to the X axis and at a distance from the center 136 of the semiconductive wafer equal to half the objective spacing of the second objective lens unit 92, while that right hand wafer alignment mark 130b on the reticle will be imaged off and to the left of the semiconductive wafer and by thereupon momentarily opening shutter 50 so that blue light passing through the aforementioned small circular portion of the reticle containing the left hand wafer alignment mark 130a selectively exposes a corresponding portion of the photosensitive film deposited on the semiconductive wafer and thereby prints the left-hand wafer alignment mark 130a on the semiconductive wafer at the aforementioned location. Similarly, the right hand wafer alignment mark 130b contained on the first reticle 12 is then printed on the right hand side of the first semiconductive wafer 14 by employing X and Y axes servo drive units 25 and 27 for moving main stage 20 to a position at which the right hand side of the semiconductive wafer is disposed directly beneath projection lens 18 so that when shutter 50 is subsequently opened the right hand wafer alignment mark 130b on the reticle will be imaged onto the right hand side of the semiconductive wafer at a location along centerline 134 thereof parallel to the X axis and at a distance from the center 136 of the semiconductive wafer equal to half the objective spacing of the second objective lens unit 92, while the left hand wafer alignment mark 130a on the reticle will be imaged off and to the right of the semiconductive wafer; and thereupon momentarily opening shutter 50 so that blue light passing through the aforementioned small circular portion of the reticle containing the right hand wafer alignment mark 130b selectively exposes a corresponding portion of the photosensitive film deposited on the semiconductive wafer and thereby prints that right hand wafer alignment mark 130b on the semiconductive wafer at the aforementioned location. Following the foregoing wafer alignment mark printing operation, the first semiconductive wafer 14 is removed from alignment and exposure system 10 and is subsequently processed in accordance with well known techniques to develop the selectively exposed photosensitive film thereon, and for example, to etch the wafer alignment marks 130a and 130b printed on the semiconductive wafer into the semiconductive wafer.

In initially setting up alignment and exposure system 10 left and right hand prealignment reticles 138a and 138b are manually adjusted (by adjustment screws not shown) to precisely align left and right hand wafer alignment marks 140a and 140b respectively contained thereon with the X axis of motion of main stage 20 as hereinafter explained. These wafer alignment marks 140a and 140b are identical to reticle alignment marks 78a and 78b contained on reticle 12 but are spaced apart along the X axis in correspondence with the objective spacing of the second objective lens unit 92 and, hence, with the spacing of the wafer alignment marks 130a and 130b previously printed and then etched or otherwise formed on each semiconductive wafer 14. Thus, once a semiconductive wafer 14 has been put back in alignment and exposure system 10 and placed on vacuum chuck 131, it may quickly be precisely aligned with respect to the X axis of motion of main stage 20 and, hence, with respect to reticle 12 by simply employing the X and Y axes servo drive units 25 and 27 for moving the main stage to align the wafer alignment marks 130a and 130b on the semiconductive wafer with the corresponding wafer alignment marks 140a and 140 contained on prealignment reticles 138a and 138b, respectively.

The first semiconductive wafer 14 of the first batch of semiconductive wafer being processed by alignment and exposure system 10 can be used in performing the prealignment reticle adjustment operation. In order to do this the first semiconductive wafer 14 has to be precisely aligned with the first reticle 12 of the first set of reticles being employed with alignment and exposure system 10 and, hence, with the X axis of motion of main stage 20 so as to become a secondary frame of reference for use in aligning prealignment reticles 138a and 138b with the X axis motion of the main stage. This is accomplished by placing the first semiconductive wafer 14 on vacuum chuck 131 in nominal alignment with the first reticle 12; by employing the θ servo drive unit 51 to open shutter 50; by employing the Y axis servo drive unit 66 for moving slide 58 to position mark plate 62 at an operative position between positive lenses 46 and 47 so as to illuminate small circular regions of reticle 12 containing the left and right hand reticle alignment marks 78a and 78b as previously described in connection with the substage adjustment and reticle alignment operations; by returning slide 123 and objective lenses 88a and 88b of the first objective lens unit 90 to the positions described above in connection with the reticle alignment operation, if slide 123 and objective lenses 88a and 88b are not already in those positions (however, they should in fact already be in those positions since they do not need to be moved therefrom during alignment of the first reticle of the first set with reference mark 26 of during subsequent printing of the wafer alignment marks 130a and 130b on the first semiconductive wafer 14); and by employing main stage 20 to perform successive X axis, θ rotational, and Y axis alignments of the wafer alignment marks 130a and 130b on the first semiconductive wafer with respect to the projected images of the illuminated reticle alignment marks 78a and 78b contained on the first reticle.

The X axis alignment of wafer alignment marks 130a and 130b with respect to the projected images of reticle alignment marks 78a and 78b may be performed by employing the X and Y axes servo drive units 25 and 27 for moving main stage 20 to position the left hand wafer alignment mark 130a directly beneath the projected image of the left-hand reticle alignment mark 78a; by employing the left hand objective lens 88a of the first objective lens unit 90 to view the aerial image of portions of the left hand wafer alignment mark 130a illuminated by the projected image of the left hand reticle alignment mark 78a; and, while viewing that aerial image, by further employing the servo drive units 25 and 27 for moving the main stage to align the left hand wafer alignment mark 130a symmetrically with respect to the projected image of the left hand reticle alignment mark 78a. This should normally be effective to complete the X axis alignment of both wafer alignment marks 130a and 130b formed on the first semiconductive wafer with respect to the projected images of the corresponding reticle alignment marks 78a and 78b contained on the first reticle 12.

The θ rotation alignment of wafer alignment marks 130a and 130b with respect to the projected images of the reticle alignment marks 78a and 78b may next be performed by employing the X axis servo drive unit 25 for moving main stage 20 to position the right hand wafer alignment mark 130b beneath the projected image of the right hand reticle alignment mark 78b by employing the right hand objective lens 88b of the first objective lens unit 90 to view the aerial image of portions of the right hand wafer alignment mark 130a illuminated by the projected image of the right hand reticle alignment mark 78b; and, while viewing that aerial image, by employing a θ servo drive unit 29 for rotating chuck 131 on the main stage to move the right hand wafer alignment mark 130b from its original position to an intermediate position approximately half the rotational distance (center-to-center) between its original position and the position of the projected image of the right hand reticle alignment mark 78b. This has the effect of moving both wafer alignment marks 130a and 130b formed on the first semiconductive wafer 14 into nominal θ rotational alignment with the projected images of the corresponding reticle alignment marks 78a and 78b contained on the first reticle 12. Each of these wafer alignment marks 130a and 130b is therefore offset approximately the same distance (center-to-center) along the Y axis from the projected image of the corresponding reticle alignment mark 78a or 78b.

The Y axis alignment of wafer alignment marks 130a and 130b with respect to the projected images of reticle alignment marks 78a and 78b may be performed by employing the X axis servo drive unit 25 for moving main stage 20 to position the left hand wafer alignment mark 130a beneath the projected image of the left hand reticle alignment mark 78a; by employing the left hand objective lens 88a of the first objective lens unit 90 to view the aerial image of the left hand wafer alignment mark 130a illuminated by the projected image of the left hand reticle alignment mark 78a and, while viewing that aerial image, by employing the Y axis servo drive unit 27 and, if necessary, the X axis servo drive unit 25 for moving the main stage to align the left hand wafer alignment mark 130a symmetrically with respect to the projected image of the left hand reticle alignment mark 78a. This has the effect of moving both wafer alignment marks 130a and 130b formed on the first semiconductive wafer 14 into nominal Y axis alignment with the projected image of the corresponding reticle alignment marks 78a and 78b contained on the first reticle 12.

As mentioned above, the X axis alignment of both wafer alignment marks 130a and 130f formed on the first semiconductive wafer 14 with respect to the projected images of the corresponding reticle alignment marks 78a and 78b contained on the first reticle 12 should be completed at the end of the initial X axis alignment step. However, if any X axis misalignment should remain, it will be observed and can be eliminated while performing the Y axis alignment step. Due to the difficulty of precisely estimating half the rotational distance (center-to-center) between the right-hand wafer alignment mark 130b and the projected image of the corresponding reticle alignment mark 78b during the θ rotational alignment step and due also to the resulting differences in the distances the left and right hand wafer alignment marks 130a and 130b are offset along the Y axis from the projected images of the corresponding reticle alignment marks 78a and 78b (center-to-center), several iterations of the θ rotational and Y axis alignment steps are normally required to complete those alignments. Each such iteration of the θ rotational and Y axis alignment steps should reduce any θ rotational and Y axis misalignments by at least half.

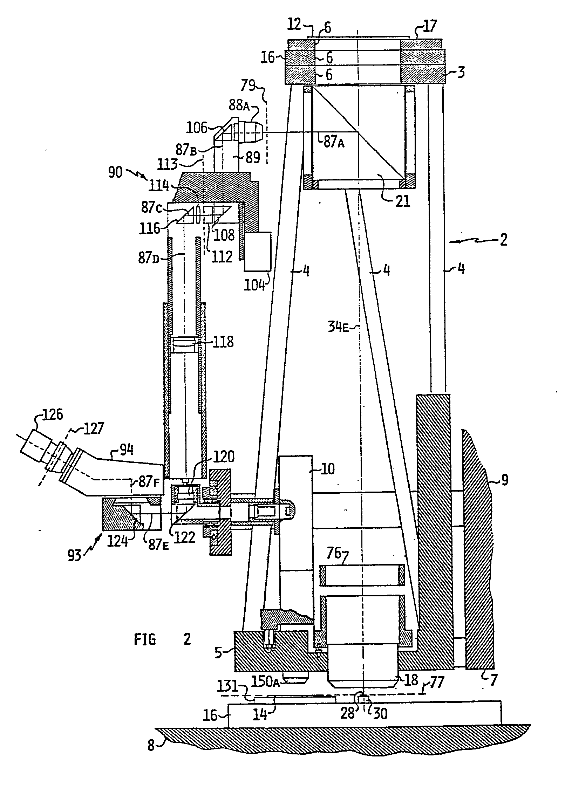

Once the X axis, θ rotational, and Y axis alignments of both wafer alignment marks 130a and 130b on the first semiconductive wafer 14 with respect to the projected images of the corresponding reticle alignment marks 78a and 78b on the first reticle 12 have been completed (i.e., any X axis, θ rotational, and Y axis misalignments have become unobservable with the first objective lens unit 90), the wafer alignment marks 130a and 130b of the first semiconductor wafer are precisely aligned with respect to the X axis of motion of main stage 20. The first semi-conductive wafer 14 has therefore become a secondary frame of reference that may now be employed for aligning the wafer alignment marks 140a and 140b contained on prealignment reticles 138a and 138b, respectively, with the X axis of motion of main stage 20 during the prealignment reticle adjustment operation. Accordingly, the X and Y axes servo drive units 25 and 27 are employed for moving main stage 20 to locate the first semiconductive wafer 14 in the prealignment position shown in Figure 1. In this position the left and right hand wafer alignment marks 130a and 130b on the first semiconductive wafer 14 are disposed beneath the corresponding left and right hand wafer alignment marks 140a and 140b on the left and right hand prealignment reticles 138a and 138b, respectively, and equidistantly along the X axis with respect to the optical axis of projection lens 18. The manner in which the prealignment reticle adjustment operation is performed will now be described with reference to the parts of alignment and exposure system 10 employed in that operation.

With reference now particularly to Figures 1A, 1C and 2, each of the prealignment reticles 138a and 138b is mounted along a corresponding vertically extending portion 142a of a dual optical path 142a-c (on the upright portion 10 of the base 5 of tower 2) for both pivotal movement about and translational movement relative to that portion of dual optical path 142a-c (as manually controlled by adjustment screws not shown) so as to permit alignment of the wafer alignment mark 140a or 140b contained thereon with the corresponding wafer alignment mark 130a or 130b formed on the first semiconductive wafer 14. A separate fiber optical light pipe 144 is fixedly mounted at one end along each of the vertically extending portions 142a of dual optical path 142a-c directly above the corresponding prealignment reticle 138a or 138b. The other end of each of these fiber optic light pipes 144 is optically coupled to a secondary light source 146 of the projection lamp type for emitting illuminating light having a wavelength of 525 nanometers or greater. Illuminating light from this secondary light source 146 passes through fiber optic light pipes 144 and downwardly along the vertically extending portions 142a of dual optical path 142a-c through the corresponding prealignment reticles 138a and 138b.

The second objective lens unit 92 includes a separate beam splitter 148 fixedly mounted along each of the vertically extending portions 142a of dual optical path 142a-c for transmitting fifty percent of the light passing through the corresponding prealignment reticle 138a or 138b downwardly along that portion of dual optical path 142a-c. It also includes left and right hand objective lenses 150a and 150b each comprising a 10:1 objective lens fixedly mounted along a corresponding different one of the vertically extending portions 142a of dual optical path 142a-c directly below the corresponding beam splitter 148. When the first semiconductive wafer 14, or any subsequent semiconductive wafer, is located in the prealignment position shown in Figure 1, these left and right hand objective lenses 150a and 150b are disposed directly above left and right hand portions of the semiconductive wafer that contain the left and right hand wafer alignment marks 130a and 130b, respectively, since those wafer alignment marks were spaced apart along the X axis by a distance equal to the objective spacing of the second objective lens unit 92 as described above. The left and right hand objective lenses 150a and 150b focus the light passing through the corresponding left and right hand prealignment reticles 138a and 138b and the corresponding beam splitters 148 at the first image plane 77 adjacent to main stage 20 and directly beneath those objective lenses, thereby projecting images of the left and right hand wafer alignment marks 140a and 140b contained on those prealignment reticles onto the corresponding left and right hand wafer alignment mark containing regions of the semiconductive wafer 14 located in the prealignment position. Fifty percent of the light reflected vertically upward from each of these left and right hand wafer alignment mark containing regions of semi-conductive wafer 14 through the corresponding objective lens 150a and 150b is reflected by the corresponding beam splitter 148 along a horizontally extending portion 142b of dual optical path 142a-c.

The second objective lens unit 92 also includes a separate beam bender 152 fixedly mounted along each horizontally extending portion 142b of dual optical path 142a-c adjacent to the corresponding beam splitter 148 so as to deflect the reflected light therefrom to a corresponding face of a split field prism 154. Split field prism 154 is fixedly mounted along both horizontally extending portions 142b of dual optical path 142a-c as to deflect the reflected light from each beam bender 152 in side-by-side relationship along a common horizontally extending portion 142c of dual optical path 142a-c to a fifth image plane 155 positioned directly in front of split field prism 154 and the same optical distance from beam splitters 148 as are prealignment reticles 138a and 138b. A 5:1 objective lens 156 is fixedly mounted along the common horizontally extending portion of dual optical path 142a-c for viewing the fifth image plane. The horizontally extending portion 142c of dual optical path 142a-c is axially aligned with the horizontally extending portion 87e of dual optical path 87a-f to permit use of the first and second objective lens units 90 and 92 with the same binocular lens unit 93 as determined by the position of slide 123. Accordingly, a positive lens 158 is fixedly mounted on slide 123 for movement into an operative position in those axially aligned horizontally extending portions 87e and 142c of dual optical paths 87a-f and 142a-f between beam bender 124 and objective lens 156, as shown in Figures 1C and 11, when the second objective lens unit 92 is to be employed. With positive lens 158 so positioned, light from objective lens 156 passes through positive lens 158 and along horizontally extending portion 87e of dual optical path 87a-f to beam bender 124 from which it is deflected upward along vertically extending portion 87f of dual optical path 87a-f to the fourth image plane 127 directly in front of ocular lenses 126 of binocular head 94.

The various elements of the second objective lens unit 92 are arranged along dual optical path 142a-c as described above so that objective lenses 150a and 150b focus the light reflected from the left and right hand wafer alignment mark containing regions of the semiconductive wafer 14 disposed in the prealignment position at the fifth image plane 155 directly in front of split field prism 154. This provides aerial images of the left and right hand wafer alignment marks 130a and 130b disposed on the semiconductive wafer in the first image plane 77 directly beneath objective lenses 150a and 150b, and of the images of the corresponding left and right hand wafer alignment marks 140a and 140b contained on the prealignment reticles 138a and 138b and projected onto the semiconductive wafer directly beneath those objective lenses, in the fifth image plane 155. Objective lens 156 has a focal length equal to the distance from its input pupil back along the horizontally extending portion 142c of dual optical path 142a-c to the fifth image plane. Positive lens 158, when positioned in the axially aligned horizontally extending portions 87e and 142c of dual optical paths 87a-f and 142a-c, has a focal length equal to the distance forward along portions 87e and 87f of dual optical path 87a-f to the fourth image plane 127 directly in front of ocular lenses 126 of binocular head 94. Objective lens 156 and positive lens 158 therefore reimage the aerial images provided in the fifth image plane 155 at the fourth image plane 127.

The prealignment reticle adjustment operation may therefore be performed by employing slide 123 to move positive lens 158 into the operative position in the axially aligned horizontally extending portions 87e and 142c of dual optical paths 87a-f and 142a-c; by thereupon employing binocular lens unit 93 with the second objective lens unit 92 to view the aerial images of those portions of the left and right hand wafer alignment marks 130a and 130b disposed on the first semiconductive wafer 14 that are illuminated by the projected images of the corresponding wafer alignment marks 140a and 140b disposed on prealignment reticles 138a and 138b; and, while viewing those aerial images, by manually adjusting the prealignment reticles to position the projected images of the left and right hand wafer alignment marks 140a and 140b disposed thereon in precise θ rotational, X axis, and Y axis alignment with the corresponding left and right hand wafer alignment marks 130a and 130b disposed on the first semiconductive wafer as shown in Figure 12. This precisely aligns the prealignment reticles 138a and 138b with the X axis of motion of main stage 20 and positions them equidistantly along the X axis with respect to the optical axis of projection lens 18 so that they may subsequently be employed in the precision prealignment of other semiconductive wafers 14 without further adjustment. Although the prealignment reticle adjustment operation should not normally have to be repeated during the lifetime of alignment and exposure system 10, it may be checked at any time by employing another semiconductive wafer in the same manner as described above for the first semiconductive wafer.

Each semiconductive wafer 14 processed by alignment and exposure system 10 subsequent to the prealignment reticle adjustment operation, may be precision prealigned with respect to the X axis of motion of main stage 20 and with respect to the optical axis of projection lens 18 by simply employing the X and Y axes servo drive units 25 and 27 for moving main stage 20 to position the semiconductive wafer in the prealignment position shown in Figure 1; by moving slide 123 to move positive lens 158 to the operative position; by employing binocular lens unit 93 to view the aerial images provided by the second objective lens unit 92 as described above; and, while viewing those aerial images, by employing the X axis, Y axis, and θ servo drive units 25, 27, und 29 for moving the main stage and rotating vacuum chuck 17 to precisely align the left and right hand wafer alignment marks 130a and 130b formed on the semiconductive wafer with the corresponding left and right hand wafer alignment marks 140a and 140b contrained on the prealignment reticles 138a and 138b. Following the precision prealignment of a semiconductive wafer 14 it may be subjected to a step-and-repeat printing operation in the same manner as described below for the first semiconductive wafer 14.

Assuming that the first reticle 12 of the first step of reticles being employed with and the first semiconductive wafer 14 of the first batch of semiconductive wafers being processed by alignment and exposure system 10 were employed to perform the previously-described prealignment reticle adjustment operation (rather than a special set-up reticle and a special set-up wafer), the first semiconductive wafer is then removed from alignment and exposure system 10 so that a photosensitive film may be deposited over the first semiconductive wafer along with the other semiconductive wafers of the same batch. The first semiconductive wafer 14 is thereafter placed back in alignment and exposure system 10 on vacuum chuck 17 and precision prealigned with prealignment reticles 138a and 138b as described above. Referring again to Figures 1A—C and 2, the first level of microcircuitry contained on a central portion 160 of the first reticle may now be printed at each of a desired array of adjacent regions 162 of the first semiconductive wafer as shown in Figure 6. This is accomplished by employing the Y axis servo drive unit 66 for moving slide 58 to position mask plate 60 in an operative position between positive lenses 46 and 47 with a square central opening 69 of mask plate 60 permitting illumination of the entire microcircuitry-containing central portion 160 of the first reticle 12 held by vacuum holder 17 when shutter 50 is moved to the open position shown in dashed lines in Figure 1; by employing the X and Y axes servo drive units 25 and 27 to step main stage 20 so as to successively position each of the desired array of adjacent regions 162 of the first semiconductive wafer 14 held by vacuum chuck 17 directly beneath projection lens 18 in the order indicated by the dashed arrows in Figure 6; and by employing the θ servo drive unit 51 to momentarily move shutter 50 to the open position when each of those regions 162 of the first semiconductive wafer is so positioned, thereby repetitively selectively exposing the photosensitive film deposited on the first semiconductive wafer so as to print the first level of microcircuitry contained on the first reticle at each of those regions of the first semiconductive wafer. The square central opening 68 of mask plate 60 is of a size for permitting illumination of the entire microcircuitry-containing central portion 160 of each reticle 12 (an area of about 100 millimeters or less square) as described above, while preventing illumination and, hence, printing of the reticle alignment marks 78a and 78b and any wafer alignment marks 130a and 130b contained on the reticle, during the step-and-repeat printing operation.

Following this step-and-repeat printing operation, the first semiconductive wafer 14 is removed from alignment and exposure system 10 and processed to develop the selectively exposed photosensitive film thereon and to selectively etch, diffuse, plate, implant or otherwise process the first semiconductive wafer in accordance with well known techniques for forming the first level of microcircuitry on the first semiconductive wafer at each of the desired array of adjacent regions 162. Each additional semiconductive wafer 14 of the first batch and every semiconductive wafer of every other batch to be processed by alignment and exposure system 10 may also be processed with the first reticle 12 (and possibly a second reticle as hereinafter explained) of the aforementioned set or any other set of reticles in exactly the same manner as described above in connection with the first semiconductive wafer of the first batch (except for the prealignment reticle adjustment operation) to initially print and form the left and right hand wafer alignment marks 130a and 130b (and possibly other alignment marks as hereinafter explained) on the semiconductive wafer and then to step-and-repeatedly print the first level of microcircuitry contained on the first reticle (or a second reticle as hereinafter explained) of the set of reticles at each of the desired array of adjacent regions of the semiconductive wafer. In this case each semiconductive wafer 14 is removed from alignment and exposure system 10 following the initial alignment mark printing operation to form the alignment marks on the semiconductive wafer, for example, by a deep etching operation, is then placed back in the alignment and exposure system and precision prealigned in preparation for the subsequent first step-and-repeat microcircuitry printing operation, and is removed again from the alignment and exposure system following the first step-and-repeat microcircuitry printing operation to form the first level of microcircuitry on the semiconductive wafer.

Alternatively, however, in cases where the steps of forming the wafer alignment marks and the first level of microcircuitry on a semiconductive wafer 14 (other than the first semiconductive wafer employed to perform the prealignment reticle adjustment operation) do not require inconsistent processing, such as different depths of etching, it is not necessary to remove the semiconductive wafer from alignment and exposure system 10 between the initial wafer alignment mark printing operation and the first step-and-repeat microcircuitry printing operation (the wafer alignment marks 130a and 130b then printed on the semiconductive wafer not being required for the prealignment reticle adjustment operation or for alignment of the first level of microcircuitry with a previously formed level of microcircuitry). In such cases the first step-and-repeat printing operation can be performed to print the first level of microcircuitry contained on the first reticle of the set at each of the desired array of adjacent regions 162 of the semiconductive wafer without first performing the precision prealignment operation. Upon completion of the first step-and-repeat printing operation, the semiconductive wafer 14 is removed for the first time from alignment and exposure system 10 and processed as previously indicated to form the wafer alignment marks 130a and 130b (and any other wafer alignment marks that may have also been printed as hereinafter described) on the semiconductive wafer and also to form the first level of microcircuitry at each of the desired array of adjacent regions 162 of the semiconductive wafer.

On the first level of microcircuitry contained on the first reticle 12 (or the second reticle as hereinafter described) of the set of reticles being employed with alignment and exposure system 10 has been printed and formed on each of the desired array of adjacent regions 162 of each semiconductive wafer 14 of the batch or batches being processed with the alignment and exposure system, that reticle is removed from the vacuum holder 17 of stage 16. The next reticle 12 of the set is then placed on the vacuum holder 17 of stage 16 in nominal alignment with the X axis of motion of main stage 20 and is thereupon precisely aligned with the Y axis of motion in exactly the same manner as previously described for the first reticle of the set (i.e., by employing the X and Y axes servo drive units 25 and 27 for moving the main stage to position reference mark 26 directly beneath projection lens 18; by employing Y axis servo drive unit 66 for moving slide 58 to position mask plate 62 in an operative position between positive lenses 46 and 47 so as to illuminate the reticle alignment marks 78a and 78b on the reticle when shutter 50 is opened by employing θ servo drive unit 51 to open shutter 50; by employing slide 123 to move beam bender 122 into the operative position in the horizontally extending portion 87e of dual optical path 87a-f and thereby permit use of the first objective lens unit 90 with binocular lens unit 93 for viewing the aerial images of the end portions of reference mark 26, which are illuminated by the projected images of the objective lenses 88a and 88b for viewing those aerial images; and, while viewing those aerial images, by employing the X axis and differential Y axis servo drive units 84, 86a and 86b for moving stage 16 so as to precisely align the projected images of the reticle alignment marks 78a and 78b with the illuminated end portions of reference mark 26.

The second level of microcircuitry contained on this next reticle 12 of the set is thereupon printed and formed at each of the desired array of adjacent regions 162 on each semiconductive wafer 14 of the batch being processed by alignment and exposure system 10 in alignment with the first level of microcircuitry previously printed and formed at each of those regions on each of those semiconductive wafers. This is accomplished for each of those semiconductive wafers 14 by deposition a photosensitive film over the semiconductive wafer; by placing the semiconductive wafer back in alignment and exposure system 10 on vacuum chuck 17 in nominal alignment with the X axis of motion of main stage 20; by precision prealigning the semiconductive wafer in exactly the same manner as previously described for the first semiconductive wafer being processed by the alignment and exposure system (i.e., by employing the X and Y axes servo drive units 25 and 27 for moving the main stage to locate the semiconductive wafer in the prealignment position; by employing slide 123 to move positive lens 158 into the operative position in the axially aligned horizontally extending portions 87e and 142c of dual optical paths 87a-f and 142a-c and thereby permit use of the second objective lens unit 92 with binocular lens unit 93 for viewing the aerial images of the left and right hand wafer alignment marks 130a and 130b disposed on the semiconductive wafer and illuminated by the projected images of the corresponding left and right hand wafer alignment marks 140a and 140b disposed on the prealignment reticles 138a and 138b and, while viewing those aerial images, by employing the X axis, Y axis, and θ servo drive units 25, 27, and 29 for moving the main stage and rotating the vacuum chuck so as to precisely align the left and right hand wafer alignment marks 130a and 130b on the semi-conductive wafer with the projected images of the corresponding left and right hand wafer alignment marks 150a and 150b on the prealignment reticles); by then step-and-repeat printing the second level of microcircuitry contained on the central portion 160 of the reticle at each of the same desired array of adjacent regions 162 of the semiconductive wafer in exactly the same manner as also previously described for the first semiconductive wafer being processed by the alignment and exposure system (i.e., by employing the Y axis servo drive unit 66 for moving slide 58 so as to position mask plate 60 in an operative position between positive lenses 46 and 47 and thereby illuminate the entire microcircuitry-containing central portion 160 of the reticle when shutter 50 is opened; by employing the X and Y axes servo drive units 25 and 26 for stepping the main stage to successively position each of the same desired array of adjacent regions 162 of the semiconductive wafer directly beneath projection lens 18 in the same order as before; and by employing the θ servo drive unit 51 to momentarily open shutter 50 when each of those regions 162 of the semi-conductive wafer is so positioned and thereby repetitively selectively expose the photosensitive film deposited on the semiconductive wafer so as to print the second level of microcircuitry contained on the reticle at each of those regions 162 of the semiconductive wafer); by thereupon removing the semiconductive wafer from the alignment and exposure system; and by subsequently processing the semiconductive wafer to develop the selectively exposed photosensitive film thereon and form the second level of microcircuitry at each of the same desired array of adjacent regions 162 of the semiconductive wafer.

The foregoing reticle alignment and wafer alignment, printing, and processing operations are repeated for each remaining reticle 12 of the set of reticles being employed with alignment and exposure system 10 in processing each semiconductive wafer 14 of the batch of semi-conductive wafers being processed by the alignment and exposure system so as to print and form each successive level of microcircuitry contained on those reticles at each of the same desired array of adjacent regions 162 on each of those semiconductive wafers in alignment with the levels of microcircuitry previously formed at each of those same regions on each of those semiconductive wafers. Following completion of this processing each semiconductive wafer 14 is typically scribed alongside each row and column of the desired array of adjacent regions 162 of the semiconductive wafer so as to form a plurality of individual die each containing one of the regions 162. These dice are then typically subjected to die bonding, wire bonding, and other well known processing operations to form integrated circuits or the like.

The manner in which a precision alignment step-and-repeat printing operation is performed will now be described with reference to the parts of alignment and exposure system 10 employed in that operation. As shown in Figure 1C, a first end of a fiber optic light pipe 174 is fixedly mounted along a horizontally extending optical path 175 axially aligned with the horizontally extending portion 34d of optical path 34a-e. A second end of this fiber optic light pipe 174 is fixedly mounted adjacent to a blue filter at a corresponding opening in elliptical reflector 36. A beam of blue illuminating and exposure light from mercury arc lamp 32 therefore passes through fiber optic light pipe 174 and along the horizontally extending optical path 175. A normally closed shutter 176 pivotally mounted adjacent to the horizontally extending optical path 175 is pivoted into that optical path (as shown in solid lines) when closed so as to block passage of the beam of light therealong and is pivoted out of that optical path (as shown in dashed lines) when opened so as to permit passage of the beam of light therealong. These pivotal movements of shutter 176 are controlled by a θ servo drive unit 166 coupled thereto.

The first end of fiber optic light pipe 174, the shutter 176, the θ servo drive unit 177, and a mask plate 182 are all mounted on a stage 178 for movement therewith along the X and Z axes. Stage 178 is moved along the X and Z axes by X and Z axes servo drive units 179 and 181 to selectively position mask plate 182 in a vertical plane orthogonally intersecting the horizontally extending optical path 175 at a point midway between fiber optic light pipe 174 and a positive lens 184. Mask plate 182 has a small circular opening 186, as best shown in Figure 13, for permitting the beam of light passing along the horizontally extending optical path 175, when shutter 176 is opened, to illuminate a corresponding circular area located on the second or any succeeding reticle 12 (held by vacuum holder 17 of stage 16) and containing one (and only one) of small wafer alignment marks (not shown) disposed on that reticle. Positive lens 184 is fixedly mounted in the horizontally extending optical path 175 so as to project light passing through the small circular opening 186 in mask plate 182 to the entrance pupil of imaging lens 56. Beam splitter 48 transmits twenty percent of the light passing through positive lens 184 forward along the horizontally extending portion 34d of optical path 34a-e. This light thereupon passes along the remainder of optical path 34a-e and along dual optical path 87a-f in the same manner as previously described in connection with the substage adjustment operation so that the first objective lens unit 90 may be used with binocular lens system 93, as hereinafter described, to view an aerial image of one of the small wafer alignment marks on the semiconductive wafer 14, when that small wafer alignment mark is positioned directly beneath projection lens 18 and illuminated by a projected image of the corresponding small wafer alignment mark disposed on the second or one of the succeeding reticles of the set.

Once the set of small wafer alignment marks 172 has been formed on the semiconductive wafer 14 alongside each of the selected regions 160 thereof, a photosensitive film is deposited over the semiconductive wafer (this is typically done at one time with the other semiconductive wafers of the batch). The semiconductive wafer 14 is then put back in alignment and exposure system 10 on vacuum chuck 17 in nominal alignment with the X axis of motion of main stage 20. It is thereupon precision prealigned with prealignment reticles 138a and 138b in exactly the same manner as previously described. In preparation for the precision alignment step-and-repeat printing operation, the X and Z axes servo drive units 179 and 181 are employed for moving stage 178 so as to position mask plate 182 for illuminating only the small wafer alignment mark 170 on the second reticle 12, when shutter 176 is subsequently opened. Additionally, slide 123 is employed to move beam bender 122 into the operative position in the horizontally extending portion 87e of dual optical path 87a-f so that binocular lens unit 93 may be used with the first objective lens unit 90 to view an aerial image of the first small wafer alignment mark alongside a selected region 162 of the semiconductive wafer 14 and of the corresponding small wafer alignment mark on the second reticle 12, when shutter 176 is opened.

The precision alignment step-and-repeat printing operation may now be performed by employing the X and Y axes servo drive units 25 and 27 for stepping main stage 20 to position the selected region 162 in the first quadrant of the semiconductive wafer 14 directly beneath projection lens 18, thereby positioning the first small wafer alignment mark disposed alongside that selected region in nominal alignment with the image of the corresponding small wafer alignment mark on the second reticle to be projected onto the semiconductive wafer when the shutter 176 is subsequently opened by thereupon employing the θ servo drive unit 177 for moving shutter 176 to the open position (shown in dashed lines) whereupon mask plate 182 illuminates the small wafer alignment mark contained on the second reticle without illuminating either of the larger reticle alignment marks 78a and 78b or the microcircuitry-containing central portion 160 of the second reticle; by employing the first objective lens unit 90 with binocular lens unit 93 to view the aerial image of the first small wafer alignment mark disposed alongside the selected region 162 in the first quadrant of the semiconductive wafer and illuminated by the projected image of the corresponding wafer alignment mark contained on the second reticle; while viewing that aerial image, by employing the X and Y axes servo drive units 25 and 27 for moving the main stage so as to precisely align that first small wafer alignment mark in the first quadrant of the semiconductive wafer with the projected image of the corresponding small wafer alignment mark on the second reticle; by measuring and storing the offset distances the main stage is moved along the X and Y axes to move the first small wafer alignment mark in the first quadrant of the semiconductive wafer from its initial nominally aligned position to its final precisely aligned position relative to the projected image of the corresponding small wafer alignment mark on the second reticle; by employing th θ servo drive unit 177 to move shutter 176 to the closed position (shown in solid lines), thereby blocking the passage of light through mask plate 182 to the second reticle; by repeating each of the preceding steps of this paragraph in exactly the same manner for the first small wafer alignment mark formed alongside the selected region 162 in each of the remaining quadrants of the semiconductive wafer by employing the four resultant pairs of offset distances (or values) along the X and Y axes to determine the manner in which the main stage should be moved along the X and Y axes during the following step-and-repeat printing operation to best fit those determined pairs of offset values while successively printing the level of microcircuitry contained on the second reticle at each of the desired array of adjacent regions 162 on the semiconductive wafer and by then step-and-repeat printing the level of microcircuitry contained on the central portion 160 of the second reticle at each of the desired array of adjacent region 162 of the semiconductive wafer in exactly the same manner as previously described, but utilizing the corrected coordinates (or pairs of X and Y axes end points) to determine each of the positions to which the main stage is moved during that step-and-repeat printing operation.

During the foregoing precision alignment step-and-repeat printing operation, the level of microcircuitry contained on the central region 160 of the second reticle 12 is successively printed at each of the desired array of adjacent regions 162 on the semiconductive wafer 14 in very precise alignment with any level of microcircuitry previously printed and formed at those same regions of the semiconductive wafer (alignments to within one-tenth of a micron being possible). Upon completion of that precision alignment step-and-repeat printing operation, the semiconductive wafer 14 is removed from alignment and exposure system 10 and processed as previously described to form the level of microcircuitry so printed at each of the desired array of adjacent regions 162 of the semiconductive wafer. The semiconductive wafer 14 is successively processed for each succeeding reticle 12 of the set of reticles in exactly the same manner as described above for the second reticle to successively print and form each level of microcircuitry contained on those reticles at each of the desired array of adjacent regions 162 of the semiconductive wafer. Following all of these processing operations the semiconductive wafer may be scribed and otherwise processed as indicated above to form a plurality of integrated circuits or the like.

At some point during the previously-described processing of a semiconductive wafer 14 with alignment and exposure system 10, the operator may desire to scan the semiconductive wafer to check for possible defects (such as might occur during an etching or depositing operation) or for some other reason. This may be done, without exposing a photosensitive film deposited over the semiconductive by employing air cylinder 54 to move green filter 45 into its operative position in the vertically extending portion 34c of optical path 34a-f, thereby passing only green illuminating light forward along that optical path when shutter 50 is opened; by employing crank 74 and air cylinder 75 to move compensating lens 76 into its operative position (shown in dashed lines in Figure 1A), thereby correcting projection lens 18 for green light; by employing θ servo drive unit 51 to open shutter 50; by employing the Y axis servo drive unit 66 for moving slide 58 to position mask plate 60 in its operative position, thereby permitting illumination of at least a portion of whatever object is positioned on main stage 20 directly beneath the projection lens (a reticle 12 may or may not then be held by vacuum holder 17 of stage 16); by employing slide 123 to move beam bender 122 into its operative position in the horizontally extending portion 87e of dual optical path 87a-f, thereby permitting use of the first objective lens unit 90 with the binocular lens unit 93 to view an aerial image of whatever region of the semiconductive wafer may be disposed directly beneath the projection lens and illuminated by the green light passing through the mask plate 60; and by employing the X and Y axes servo drive units 25 and 27 for moving the main stage to scan the semiconductive wafer beneath the projection lens.

**Claims**

1. Photometric printing apparatus including a holder (16) for holding a first object (12) in a first plane (1); a stage (20) for holding a second object (14) in a second plane (77); a light source unit (24), optically disposed on one side of the holder (16), for illuminating the first object (12); a projection lens (18), optically disposed on the other side of the holder (16) and between the holder (16) and the stage (20), for projecting an image of illuminated portions of the first object (12) onto the second object (14); and control means (25, 27), coupled to the stage (20), for moving the stage (20) to facilitate printing of an image of an illuminated portion (160) of the first object (12) at different regions (162) of the second object (14) characterized in that the light source unit (24) includes an imaging lens (56) for defining a third plane (3) conjugate to the plane (1) of the first object (12); that a field lens (72) is located adjacent to the first plane (1), and that optical means (58, 60, 62, 68a, 69; 182, 186) are located in said third plane (3).

2. Apparatus as in claim 1, characterized in that said optical means (58, 60, 62, 68a, 68b, 69, 182, 186) includes a plurality of different mask plates (60, 62, 182) having openings (68a, 68b, 69, 186) of different configuration, and being selectively usable at an operative position in said third plane (3).

3. Apparatus as in claim 1 or 2, characterized in that said light source unit (24) further includes a shutter (50, 176).

4. Apparatus as in any of the preceding claims 1 to 3, characterized in that said light source unit (24) produces exposure light from both illuminating and exposing a photosensitive film on the second object (14) and illumination light for illuminating, without exposing, the photosensitive film on the second object (14); and further includes a pair of filters (44, 45) disposed for selectively controlling whether exposure or illuminating light passes to the first object (12).

5. Apparatus as in any of the preceding claims, characterized by a beam splitter (48) arranged in a first optical path (34a—34e) between the optical means (58, 60, 62, 68a, 68b, 69; 182, 186) and the imaging lens (56).

6. Apparatus as in claim 5, characterized in that the light source unit (24) comprises a second optical path (175) for exposing light in which selectable optical means (182, 186) are located in a plane conjugate to the plane (1) of the first object (12) and which is combined with the first optical path (34a—34e) at the beam splitter (48), and that a shutter (50; 176) each is arranged in said optical paths (34a—34e; 175).

7. Apparatus as in claim 5, characterized in that the second optical path (175) comprises a fiber optic (174).

**Patentansprüche**

1. Photometrische Druckvorrichtung mit einem Halter (16) zum Halten eines ersten Gegenstandes (12) in einer ersten Ebene (1), einem Tisch (20) zum Halten eines zweiten Gegenstandes (14) if einer zweiten Ebene (77); einer Lichtquelle (24), die optisch auf einer Seite des Halters (16) zum Erleuchten des ersten Gegenstandes (12) angeordnet ist; einer Projektionslinse (18), die optisch auf der anderen Seite des Halters (16) und zwischen dem Halter (16) und dem Tisch (20) angeordnet ist, um ein Bild eines erleuchteten Abschnitts des ersten Gegenstandes (12) auf den zweiten Gegenstand (14) zu projizieren; und mit dem Tisch (20) gekuppelten Steuermitteln (25, 27) zum Bewegen des Tisches (20), um das Drucken eines Bildes eines erleuchteten Abschnittes (160) des ersten Gegenstandes (12) auf verschiedene Gebiete (162) des zweiten Gegenstandes (14) zu ermöglichen, dadurch gekennzeichnet, daß die Lichtquelle (24) eine Abbildungslinse (56) zum Definieren einer dritten, zur Ebene (1) des ersten Gegenstandes (12) konjugierten Ebene (3) umfaßt, daß eine Feldlinse (72) benachbart der ersten Ebene (1) angeordnet ist und daß optische Mittel (58, 60, 62, 68a, 69; 182, 186) in der genannten dritten Ebene (3) angeordnet sind.

2. Vorrichtung nach Anspruch 1, dadurch gekennzeichnet, daß die optischen Mittel (58, 60, 62, 68a, 68b, 69, 182, 186) mehrere unterschiedliche Masken (60, 62, 182) mit Öffnungen (68a, 68b, 69, 186) unterschiedlicher Gestalt umfassen, die wahlweise in einer Betriebsstellung in der dritten Ebene (3) verwendbar sind.

3. Vorrichtung nach Anspruch 1 oder 2, dadurch gekennzeichnet, daß die Lichtquelle (24) einen Verschluß (50, 176) aufweist.

4. Vorrichtung nach einem der Ansprüche 1 bis 3, dadurch gekennzeichnet, daß die Lichtquelle (24) Belichtungslicht sowohl zum Erleuchten als auch zum Belichten einer photoempfindlichen Schicht auf dem zweiten Gegenstand (14) und Beleuchtungslicht zum Erleuchten ohne Belichten der photoempfindlichen Schicht auf dem zweiten Gegenstand (14) erzeugt und ferner ein Paar Filter (44, 45) zur wahlweisen Kontrolle umfaßt, ob Belichtungs- oder Beleuchtungslicht den ersten Gegenstand (12) passiert.

5. Vorrichtung nach einem der vorstehenden Ansprüche, gekennzeichnet durch einen Strahlteiler (48), der in einer ersten optischen Bahn (34a—34e) zwischen den optischen Mitteln (58, 60, 62, 68a, 68b, 69; 182, 186) und der Abbildungslinse (56) angeordnet ist.

6. Vorrichtung nach Anspruch 5, dadurch gekennzeichnet, daß die Lichtquelle (24) eine zweite optischen Bahn (175) für Belichtungslicht aufweist, in welcher auswählbare optische Mittel (182, 186) in einer zur Ebene (1) des ersten Gegenstandes (12) konjugierten Ebene angeordnet sind und welche mit der ersten optischen Bahn (34a—34e) am Strahlteiler (48) zusammengeführt wird, und daß jeweils ein Verschluß (50; 176) in den optischen Bahnen (34a—34e; 175) angeordnet ist.

7. Vorrichtung nach Anspruch 5, dadurch gekennzeichnet, daß die zweite optische Bahn (175) eine Faseroptik (174) umfaßt.

**Revendications**

1. Appareil d'impression photométrique comportant un support (16) pour porter un premier objet (12) dans un premier plan (1); une platine (20) pour porter un second object (14) dans un second plan (77); une source lumineuse (24) disposée optiquement d'un premier côté du support (16) pour éclairer le premier object (12); un objectif de projection (18) disposé optiquement de l'autre côté du support (16) et entre le support (16) et la platine (20) de façon à projeter une image des parties éclairées du premier object (12) sur le second objet (14); et des moyens de commande (25, 27) couplés à la platine (20) pour déplacer la platine (20) afin de faciliter l'impression d'une image d'une partie éclairée (160) du

**0 017 759**

premier objet (12) sur différentes régions du second objet (14), caractérisé en ce que la source lumineuse (24) comprend un objectif (56) de formation d'image pour définir un troisième plan (3) conjugué avec le plan (1) du premier objet (12); en ce qu'une lentille du champ (72) est disposée adjacente au premier plan (1); et en ce que des moyens optiques (58, 60, 62; 68a, 69; 182, 186) sont disposés dans ledit troisième plan (3).

2. Appareil tel que revendiqué dans la revendication 1, caractérisé en ce que lesdits moyens optiques (58, 60, 62, 68a, 68b, 69, 182, 186) comprennent plusieurs caches différentes (60, 62, 182) qui comportent des ouvertures (68a, 68b, 69, 186) ayant des configurations différentes et que sont sélectivement utilisables dans une position active dans ledit troisième plan (3).

3. Appareil tel que revendiqué dans la revendication 1 ou 2, caractérisé en ce que ladite source lumineuse (24) comporte en outre, un obturateur (50, 176).

4. Appareil tel que revendiqué dans l'une quelconque des revendications précédentes 1 à 3, caractérisé en ce que ladite source lumineuse (24) produit une lumière d'exposition à la fois pour éclairer et pour exposer une pellicule photosensible portée par le second objet (14) et une lumière d'éclairement pour éclairer sand l'exposer la pellicule photosensible portée par le second objet (14); et en ce qu'il comporte, en outre, une paire de filtres (44, 45) disposés de manière à commander sélectivement celle des lumières d'exposition ou d'éclairement qui traverse la premier objet (12).

5. Appareil tel que revendiqué dans l'une quelconque des revendications précédentes caractérisé par un diviseur de faisceau (48) disposé dans un premier trajet optique (34a—34e) entre les moyens optiques (58, 60, 62, 68a, 68b, 69; 182, 186) et l'objectif (56) de formation d'image.

6. Appareil tel que revendiqué dans la revendications 5, caractérisé en ce que la source lumineuse (24) comprend un second trajet optique (175) pour la lumière d'exposition dans lequel des moyens optiques sélectionnables (182, 186) sont disposés dans un plan conjugué au plan (1) du premier objet (12) et qui est combiné avec le premier trajet optique (34a—34e) dans le diviseur de faisceau (48) et en ce qu'un obturateur (50; 176) est disposé dans chacun desdits trajets optiques (34a—34e; 175).

7. Appareil tel que revendiqué dans la revendication 5, caractérisé en ce que le second trajet optique (175) comprend une fibre optique (174).

FIG 1A

FIG 1B

FIG 1C

0 017 759

3

FIG 2

0 017 759

FIG 3

FIG 4

5

FIG 5

FIG 6